# FASCICULE DE BREVET EUROPEEN

(11) **EP 3 671 578 B1**
(45) Date de publication et mention de la délivrance du brevet: **19.02.2025**
(21) Numéro de dépôt: 19218371.3
(22) Date de dépôt: 19.12.2019
(51) Int. Cl.: G06N 10/20, G06N 10/80

(54) **PROCÉDÉ D'ANALYSE D'UNE SIMULATION DE L'EXÉCUTION D'UN CIRCUIT QUANTIQUE**
ANALYSEVERFAHREN EINER AUSFÜHRUNGSSIMULATION EINES QUANTENSCHALTKREISES
METHOD FOR ANALYSING A SIMULATION OF THE EXECUTION OF A QUANTUM CIRCUIT

(30) Priorité: 20.12.2018 FR 1873620
(43) Date de publication de la demande: 24.06.2020
(73) Titulaire: Bull SAS, 78340 Les Clayes-sous-Bois (FR)
(72) Inventeur: QUINTIN, Jean Noël, 95870 Bezons (FR)
(74) Mandataire: Plasseraud IP

(56) Documents cités:
- WO-A1-2018/172629
- WO-A1-2019/113600
- CN-A- 101 930 395
- ANONYMOUS: "http://www.ethernut.de/nutwiki/index.php/Advanced_UART_Functions", 27 October 2016 (2016-10-27), pages 1 - 6, XP093084645, Retrieved from the Internet <URL:http://www.ethernut.de/nutwiki/index.php/Advanced_UART_Functions> [retrieved on 20230922]
- KRISTEL MICHIELSEN ET AL: "QCE: A Simulator for Quantum Computer Hardware", TURKISH JOURNAL OF PHYSICS, vol. 27, no. 5, 1 September 2003 (2003-09-01), pages 343 - 370, XP055563678
- ANONYMOUS: "Breakpoint - Wikipedia", 11 October 2017 (2017-10-11), XP055625182, Retrieved from the Internet <URL:https://en.wikipedia.org/w/index.php?title=Breakpoint&oldid=804797949> [retrieved on 20190923]
- ANH QUOC NGUYEN: "Building an effective general-purpose quantum simulator for the design and analysis of quantum circuits", 1 January 2006 (2006-01-01), XP055624722, ISBN: 978-0-542-85076-9, Retrieved from the Internet <URL:https://media.proquest.com/media/pq/classic/doc/1196418091/fmt/ai/rep/NPDF?hl=&cit:auth=Nguyen,+Anh+Quoc&cit:title=Building+an+effective+general-purpose+quantum+simulator+for+the+design+and+analysis+of+quantum+circuits&cit:pub=ProQuest+Dissertations+and+Theses&cit:vol=&cit:iss=&cit:pg=&cit:date=2006> [retrieved on 20190920]
- DAMIAN S STEIGER ET AL: "ProjectQ: An Open Source Software Framework for Quantum Computing", ARXIV.ORG, CORNELL UNIVERSITY LIBRARY, 201 OLIN LIBRARY CORNELL UNIVERSITY ITHACA, NY 14853, 23 December 2016 (2016-12-23), XP080742759
- YANGJIA LI ET AL: "Debugging quantum processes using monitoring measurements", PHYSICAL REVIEW A (ATOMIC, MOLECULAR, AND OPTICAL PHYSICS), vol. 89, no. 4, 30 April 2014 (2014-04-30), USA, pages 4233867, XP055483055, ISSN: 1050-2947, DOI: 10.1103/PhysRevA.89.042338
- LINDA ANTICOLI ET AL: "Verifying Quantum Programs: From Quipper to QPMC", ARXIV.ORG, CORNELL UNIVERSITY LIBRARY, 201 OLIN LIBRARY CORNELL UNIVERSITY ITHACA, NY 14853, 21 August 2017 (2017-08-21), XP080953882
- KRYSTA M SVORE ET AL: "Q#: Enabling scalable quantum computing and development with a high-level domain-specific language", ARXIV.ORG, CORNELL UNIVERSITY LIBRARY, 201 OLIN LIBRARY CORNELL UNIVERSITY ITHACA, NY 14853, 1 March 2018 (2018-03-01), XP080861135, DOI: 10.1145/3183895.3183901

## Description

### Domaine technique

L'invention relève du domaine des procédés d'analyse de simulations de l'exécution d'un circuit quantique.

### Technique antérieure

Pour une telle analyse, il est connu d'effectuer répétitivement un très grand nombre de simulations, afin d'obtenir l'ensemble des valeurs des états quantiques possibles.

Il est également connu d'effectuer des mesures intermédiaires lors de la simulation de l'exécution du circuit quantique.

KRISTEL MICHIELSEN ET AL: "QCE: A Simulator for Quantum Computer Hardware",TURKISH JOURNAL OF PHYSICS, vol. 27, no. 5, 1 septembre 2003 (2003-09-01), pages 343-370, décrit un émulateur pour les circuits quantiques.

### Problème technique

Ces solutions connues ne permettent pas de réaliser un bon compromis entre d'une part la simplification de l'analyse de l'exécution d'un circuit quantique et d'autre part la complétude de l'analyse réalisée.

### Résumé de l'invention

L'invention vient pallier au moins partiellement les inconvénients de l'art antérieur et améliorer le compromis précédemment évoqué.

Pour cela, selon l'invention, il va être intéressant d'une part d'être capable de suivre pas à pas l'exécution de ce circuit quantique et d'autre part d'effectuer des mesures au niveau des différentes opérations d'exécution de ce circuit quantique sans perturbation notable de l'exécution de ce circuit quantique, tout ceci à la fois afin de faciliter l'analyse de l'exécution de ce circuit quantique tout en conservant la pertinence de cette analyse, c'est-à-dire sans que d'éventuelles perturbations dans l'exécution de ce circuit quantique, notamment dues aux mesures, ne viennent dégrader la pertinence de l'analyse de l'exécution de ce circuit quantique, la rendant soit inutile soit moins utile, aboutissant alors notamment à un débogage de l'exécution de ce circuit quantique notablement moins efficace.

Pour réussir ce bon compromis entre simplification notable de l'analyse de l'exécution de ce circuit quantique d'une part et pertinence élevée de l'analyse réalisée d'autre part, l'invention, propose une combinaison particulière entre d'une part une post-sélection et d'autre part un filtrage de fixation, tous deux réalisés sur une simulation d'exécution plutôt que sur une exécution réelle.

La méthode permet donc à l'analyste de l'exécution du circuit quantique de se focaliser sur une partie de l'exécution du circuit quantique qui l'intéresse et sur le type de déroulement de cette partie d'exécution, augmentant les possibilités de débogage du circuit quantique.

### Exposé de l'invention

L'invention est définie par la revendication indépendante. Des modes particuliers de réalisation sont définis par les revendications dépendantes.

Ainsi, il s'agit de pouvoir analyser l'exécution d'un circuit quantique, notamment à des fins de débogage de ce circuit quantique. Pour cela, selon l'invention, il va être intéressant d'une part d'être capable de suivre pas à pas l'exécution de ce circuit quantique et d'autre part d'extraire de manière simple et complète, voire même transparente pour l'analyste de l'exécution de ce circuit quantique, tout ou partie des valeurs de vecteurs d'états quantiques pour certains qbits d'intérêt particulier pour cet analyste, tout ceci à la fois afin de faciliter doublement, en facilitant la focalisation sur la partie de l'exécution de ce circuit quantique considérée comme particulièrement intéressante tout en facilitant ensuite l'extraction des données relatives à cette partie d'exécution, l'analyse de l'exécution de ce circuit quantique tout en conservant la complétude de cette analyse, c'est-à-dire sans perdre ou sans sacrifier tout ou partie des états quantiques considérés comme intéressants par l'analyste, ce qui, sinon, pourrait dégrader la complétude de l'analyse et/ou le déroulement de l'analyse, aboutissant alors notamment à un débogage de l'exécution de ce circuit quantique notablement moins efficace. Pour réussir ce bon compromis entre double simplification notable de l'analyse de l'exécution de ce circuit quantique d'une part et complétude assurée de l'analyse réalisée d'autre part, l'invention, propose une combinaison particulière entre d'une part une post-sélection et d'autre part une itération quantique, tous deux réalisés sur une simulation d'exécution plutôt que sur une exécution réelle. L'invention permet à l'analyste de l'exécution de ce circuit quantique, de pouvoir d'une part se focaliser de manière simple et efficace sur la partie de l'exécution de ce circuit quantique qui l'intéresse, tout en lui rendant d'autre part plus simple ou même transparente l'extraction des données intéressantes obtenues, d'où une focalisation précise sur ce qui l'intéresse, avec une façon plus simple d'extraire justement ce qui l'intéresse. De plus, la grande simplification obtenue par l'utilisation d'un itérateur quantique permet à l'utilisateur de réaliser des opérations de post-sélection plus nombreuses et plus détaillées, sans pour autant rendre prohibitifs le temps et la difficulté d'analyse.

L'invention permet de récupérer un vecteur d'états quantiques ayant préalablement été filtré. L'analyse du vecteur d'états quantiques filtré peut ainsi être faite immédiatement après avoir récupéré ce vecteur d'états quantiques, sans nécessiter d'opérations supplémentaires sur ce vecteur d'états quantiques.

De préférence, le procédé comprend :
- une étape d'identification de chaque état quantique dudit ou desdits vecteur(s) d'états quantiques et d'un paramètre représentatif d'une probabilité qui est respectivement associé auxdits chaque état quantique, située entre l'étape de post-sélection et l'étape de récupération,
- l'étape de récupération comprenant en outre la récupération de chaque paramètre représentatif de la probabilité respectivement associé à chaque état quantique.
L'itérateur permet donc l'extraction d'informations supplémentaires sur le vecteur d'états quantiques, de manière simple et non supervisée. Cela permet donc d'améliorer encore plus la complétude de l'analyse de l'exécution.

L'étape de post-sélection d'une ou de plusieurs valeurs particulières d'un ou de plusieurs qbits est effectuée en sortie de mesure dudit ou desdits qbits.

Les mesures intermédiaires ou la mesure finale faisant partie intégrante de l'exécution, l'étape de post-sélection peut avantageusement être effectuée après l'une de ces mesures. Cela permet d'analyser pas à pas la simulation.

L'étape de post-sélection d'une ou de plusieurs valeurs particulières d'un ou de plusieurs qbits est effectuée suite à une opération par une porte quantique sur ledit ou lesdits qbits.

Ainsi, en connaissant le déroulement des opérations lors de l'exécution, l'étape de post-sélection peut être effectuée à tout moment lors de l'exécution. Cela permet donc une analyse complète et non-dégradée des états quantiques jugés intéressants à tout moment de la simulation.

Le procédé comprend :
- une étape de communication d'états quantiques d'un ou de plusieurs vecteurs d'états quantiques entre d'une part un simulateur dans lequel ces états quantiques sont stockées et d'autre part un terminal applicatif dans lequel ces états quantiques vont être analysés,
- ces états quantiques étant communiqués en plusieurs fois, la quantité de données communiquées à chaque fois ne dépassant la taille d'une mémoire tampon, cette taille de mémoire tampon étant inférieure à la taille de la mémoire stockant ces états quantiques dans le simulateur, de préférence au moins 10 fois inférieure, et préférentiellement au moins 100 fois inférieure.
Cela permet un gain de mémoire très important, surtout au niveau du terminal applicatif, dont la mémoire peut être assez limitée.

De préférence, la taille de la mémoire tampon, au niveau du terminal applicatif et au niveau du simulateur, est suffisamment grande pour que le temps de traitement du contenu de cette mémoire tampon par le terminal applicatif soit supérieur au temps de transfert des données communiquées entre le simulateur et le terminal applicatif.
Ce gain de mémoire important ne se fait alors pas ou presque pas au détriment de la vitesse de traitement des données dans le terminal applicatif.

De préférence, la taille de la mémoire tampon vaut entre 1 Mo et 100Mo, de préférence entre 3Mo et 20Mo.
La plage de mémoire est ainsi optimisée pour le compromis gain de mémoire et conservation de vitesse de traitement.

De préférence, l'étape d'analyse est suivie par une étape de débogage de l'exécution du circuit quantique.
Cela permet donc une application intéressante de l'étape d'analyse, permettant d'améliorer la qualité et l'efficacité du circuit quantique analysé.

Le procédé comprend, entre l'étape de post-sélection et l'étape d'analyse :
- une étape de filtrage de seuil fixant un seuil de probabilité en dessous duquel les états quantiques correspondants sont supprimés du vecteur d'états quantiques auquel ils appartiennent, et/ou
- une étape de filtrage de valeur, sélectionnant une valeur d'un état quantique pour laquelle les états quantiques correspondants sont conservés dans le vecteur d'états quantiques.

Plusieurs étapes de filtrage peuvent donc être effectuées sur le vecteur d'états quantiques. Le filtrage des états quantiques du vecteur d'états quantiques en fonction de différents paramètres permet d'augmenter encore la complétude de l'analyse, en se focalisant sur les états quantiques jugés intéressants. Les différents types de filtrage peuvent être combinés et/ou superposés entre eux.

De préférence, le procédé comprend, suite à l'étape de filtrage de fixation :
- une étape de renormalisation du vecteur d'états quantiques, de sorte que la somme des probabilités des états quantiques conservés dans ce vecteur d'états quantiques vaille encore 1.
L'étape de renormalisation permet d'avoir un vecteur d'états quantiques filtré cohérent, notamment lorsque des états quantiques du vecteur d'états quantiques ont été supprimés dudit vecteur d'états quantiques lors d'une des étapes de filtrage. L'étape de filtrage de fixation correspond à une opération de mesure de certains qbits dont on choisit à priori la valeur du ou des qbits après la mesure.

De préférence, le procédé est intégré dans une interface de programmation d'application (API) apte à accéder à un serveur incluant un simulateur d'exécution du circuit quantique et un module de communication avec un terminal applicatif déporté par rapport au simulateur.
Cela permet d'améliorer la facilité d'utilisation pour l'utilisateur-analyste à partir de son terminal applicatif.

De préférence, le nombre de qbits du circuit quantique est compris entre 2 et 1000, de préférence entre 10 et 50.
Le procédé d'analyse de l'invention fonctionne même avec des circuits quantique de grande taille, voire de très grande taille.

De préférence, le procédé d'analyse est implémenté en langage python. Le langage python est bien adapté à ce type de procédé d'analyse de fonctionnement de circuit quantique.

L'invention et les variantes de celle-ci peuvent permettre, de manière générale, de proposer un procédé d'analyse d'une simulation de l'exécution d'un circuit quantique permettant une analyse complète et simplifiée, notamment pour déboguer l'exécution du circuit quantique, et en particulier d'offrir un meilleur compromis entre d'une part la simplification de l'analyse de l'exécution d'un circuit quantique et d'autre part la pertinence de l'analyse réalisée.

Une telle solution permet de résoudre les problèmes posés par les solutions connues.

### Brève description des dessins

D'autres caractéristiques, détails et avantages de l'invention apparaîtront à la lecture de la description détaillée ci-après, et à l'analyse des dessins annexés, sur lesquels :
**Fig. 1**

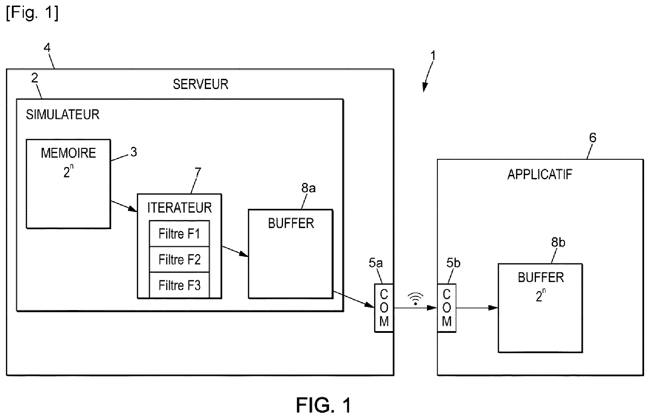

   [Fig. 1] montre un système permettant de mettre en œuvre un procédé d'analyse d'une simulation de l'exécution d'un circuit quantique
**Fig. 2**

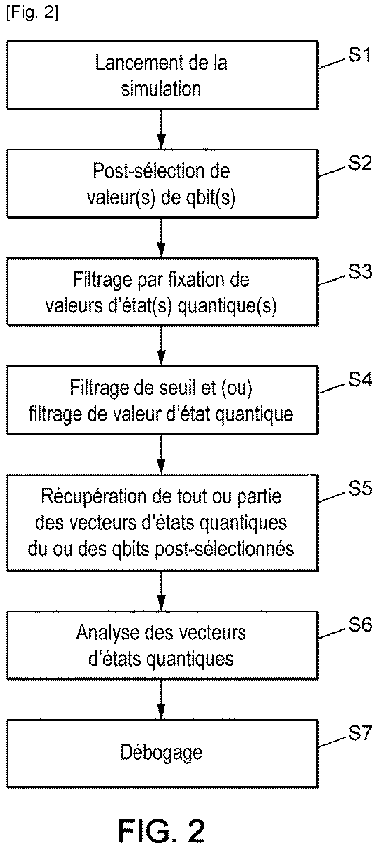

   [Fig. 2] montre un ordinogramme illustrant les principales étapes du procédé d'analyse d'une simulation de l'exécution d'un circuit quantique
**Fig. 3**

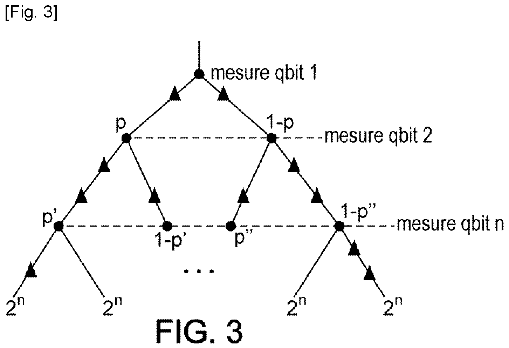

   [Fig. 3] montre un exemple de flux de l'exécution sur un vecteur d'états quantiques.

### Description des modes de réalisation

Il est maintenant fait référence à la figure 1, sur laquelle un exemple de système 1 permettant de mettre en œuvre un procédé d'analyse de l'exécution d'une simulation d'un circuit quantique est illustré.

Le système 1 comprend notamment un simulateur 2 d'un circuit quantique. Plus précisément, le simulateur 2 permet de simuler un processeur quantique.

En sortie du simulateur 2, un vecteur d'états quantiques est obtenu. Le vecteur d'états quantiques comprend 2ⁿ états quantiques, n étant le nombre de qbits sur lesquels s'effectue la simulation.

Le vecteur d'états quantiques comprend par exemple entre 2² et 2¹⁰⁰⁰. Autrement dit le circuit quantique comprend entre 2 et 1000 qbits. De préférence, le vecteur d'états quantiques comprend par exemple entre 2¹⁰ et 2⁵⁰. Autrement dit le circuit quantique comprend entre 10 et 50 qbits.

Le simulateur 2 comprend par exemple une mémoire 3. La mémoire 3 peut notamment être apte à stocker le vecteur d'états quantiques obtenu. La mémoire 3 comprend donc une capacité de stockage importante afin d'être apte à stocker un vecteur d'états quantiques comprenant entre 2² et 2¹⁰⁰⁰, et de préférence entre 2¹⁰ et 2⁵⁰ états quantiques possibles.

Le simulateur 2 est par exemple stocké sur un serveur 4.

Le serveur 4 comprend par exemple un module de communication 5, permettant d'entrer en communication avec un terminal applicatif 6 via un module de communication 5b du terminal applicatif 6.

Le terminal applicatif 6 est par exemple déporté du serveur 4. Le terminal applicatif 6 permet notamment à un analyste d'accéder au vecteur d'états quantiques afin de l'analyser, sans stocker celui-ci.

A cette fin, un itérateur 7 peut être implémenté dans le système 1. L'itérateur 7 permet une interaction entre le terminal applicatif 6 et le simulateur 2.

Plus précisément, l'itérateur 7 permet d'éviter la duplication de l'ensemble de l'information, autrement dit le vecteur d'états quantiques obtenu en sortie du simulateur 2, vers le terminal applicatif 6. En d'autre terme, l'itérateur 7 permet la récupération de l'information en sortie du simulateur 2, sur le terminal applicatif 6. L'itérateur 7 permet donc à un analyste d'avoir accès aux informations en sortie du simulateur 2 de manière simple.

Plus précisément, l'itérateur 7 boucle sur chaque état quantique du vecteur d'états quantiques obtenu en sortie du simulateur 2, de sorte que chaque état quantique peut être récupéré sur le terminal applicatif.

L'itérateur 7 peut en outre comprendre des filtres F1, F2 et F3 à appliquer sur le vecteur d'états quantiques. Ces filtres sont plus précisément décrits en référence à la figure 2.

Par ailleurs, le système 1 comprend une mémoire tampon 8a implémentée dans le simulateur 2, et une mémoire tampon 8b implémentée dans le terminal applicatif 6.

L'information obtenue en sortie du simulateur 2 est transmise au terminal applicatif 6, au moyen de l'itérateur 7, via les mémoires tampon 8a, 8b.

L'itérateur 7 est stocké dans le simulateur 2 et est en communication avec la mémoire tampon 8a.

L'utilisation de mémoires tampons 8a, 8b permet de réduire grandement la taille mémoire nécessaire pour avoir accès à l'information obtenue en sortie du simulateur 2.

La taille des mémoires tampon 8a, 8b peut être choisie de manière à ce que le temps de traitement du contenu de la mémoire tampon 8b par le terminal applicatif 6 soit supérieur au temps de transfert de l'information obtenue en sortie du simulateur 2 du simulateur 2 vers le terminal applicatif 6.

Ainsi, la taille des mémoires tampons 8a, 8b peut être choisie en 1Mo et 100Mo, et de préférence entre 3Mo et 20Mo.

Il en résulte que la taille des mémoires tampon 8a, 8b est au moins 10 fois, et de référence au moins 100 fois inférieure à la taille de la mémoire 3 stockant l'information obtenue en sortie du simulateur 2.

Ainsi, à la fin de la simulation, un vecteur d'états quantiques 2ⁿ est obtenu. Le vecteur d'état quantique 2ⁿ est stocké dans la mémoire 3 du simulateur 2. La mémoire 3 communique avec l'itérateur 7. Plus précisément, la mémoire 3 transmet des sections du vecteur d'états quantiques 2ⁿ à l'itérateur 7. L'itérateur 7 est configuré pour traiter ces sections du vecteur d'états quantiques 2ⁿ, notamment au moyen des filtres F1, F2 et F3. L'itérateur 7 est configuré pour envoyer les sections du vecteur d'états quantiques vers la mémoire tampon 8a du simulateur 2 qui les transmet, via les interfaces de communication 5a, 5b, au terminal applicatif 6. La mémoire tampon 8b du terminal application 6 reçoit les sections du vecteur d'états quantiques, de sorte qu'elles peuvent être analysées par un analyste directement sur le terminal applicatif. La communication entre le serveur 4 et le terminal applicatif 6 est par exemple faite par ondes radio ou encore par le réseau internet.

Selon une variante de réalisation, l'itérateur 7 est stocké dans la mémoire tampon 8a du simulateur 2.

La figure 2 illustre les principales étapes d'un procédé de simulation de l'exécution d'un circuit quantique selon un exemple de réalisation.

A l'étape de simulation S1, la simulation du circuit quantique est lancée. Lors de la simulation de l'exécution d'un circuit quantique, le vecteur d'états quantiques obtenu est composé d'une pluralité de qbits ayant comme état quantique 0 et 1.

En référence à la figure 3, les états quantiques des qbits du vecteur d'états quantiques ne sont pas connus. A chaque état quantique d'un qbit, une probabilité lui est associée, avec la somme des probabilités égale à 1.

Ainsi, lorsque le la mesure du qbit 2 est effectué, une probabilité p est associée à un deux états quantiques 0 ou 1, et une probabilité p-1 est associée à l'autre état quantique 0 ou 1.

A chaque mesure, une nouvelle probabilité est associée à chaque état quantique 0 ou 1 des qbits mesurés.

Ainsi, à la mesure du qbit n, une probabilité p' est associée à un des deux états quantiques 0 ou 1 pour le premier qbit, et une probabilité 1-p' est associée à l'autre des deux états quantiques 0 ou 1. De même, pour le nième qbit, une probabilité p" est associée à un des deux états quantiques 0 ou 1 du nième qbit, et une probabilité 1-p" est associée à l'autre des deux états quantiques 0 ou 1 du nième qbit.

Les probabilités p, p' et p" sont généralement différentes mais peuvent, dans certains cas être égales.

Durant la simulation, des mesures intermédiaires sont faites pour chaque qbit. Ces mesures intermédiaires influent sur l'état quantique des qbits mesurés, entraînant la fixation d'un qbit à un état quantique entre 0 et 1.

La simulation permet donc d'obtenir un arbre d'exécution, illustré sur la figure 3, sur lequel les nœuds représentent chaque qbit du vecteur d'états quantiques. Suite aux mesures intermédiaires réalisées sur les qbits, deux branches partent de chaque nœud : chaque branche représentant un état quantique du qbit mesuré auquel lui est associée sa probabilité.

A la fin de l'exécution, une pluralité de vecteurs d'états quantiques, comprenant 2ⁿ états quantiques, est obtenue.

Les triangles symbolisent des opérations quantiques pouvant être effectuées sur les qbits. Par opérations quantiques, on entend par exemple l'application de portes quantiques sur les qbits, pouvant modifier ou non la valeur des qbits.

A l'étape de post-sélection S2, une post-sélection d'une ou de plusieurs valeurs particulières d'un ou de plusieurs qbits à une ou plusieurs étapes de la simulation est effectuée. Par valeur particulière, on entend état quantique particulier.

Autrement dit, il est possible de post-sélectionner une ou plusieurs branches de l'exécution. Plus précisément, il est possible de post-sélectionner un état quantique d'un ou plusieurs qbits lors de l'exécution.

La post-sélection peut revenir à choisir des valeurs des états quantiques du vecteur d'états quantiques.

Pour une même simulation, les post-sélections de valeurs de qbits peuvent être successives. Les post-sélections peuvent également être répétitives. Par exemple, il est possible de post-sélectionner plusieurs fois la même valeur d'un qbit. Par exemple, il est possible de post-sélectionner plusieurs fois différentes valeurs pour un même qbit. Par exemple, il est possible de sélectionner plusieurs fois différentes valeurs de différents qbits.

Dans la suite de la description, le terme « la post-sélection » est utilisé, bien que plusieurs post-sélections puissent être effectuées, tel que décrit ci-avant.

La post-sélection est effectuée en plusieurs étapes de la simulation. Par exemple, la post-sélection est effectuée en sortie de mesure des qbits.

La post-sélection est effectuée suite à une opération par une porte quantique sur le qbit.

Puis, une étape de filtrage de fixation S3 est réalisée. Le filtrage de fixation fixe la valeur d'un ou de plusieurs états quantiques du ou des vecteur d'états quantiques issus de la ou des post-sélections de qbits.

Les termes « vecteur d'états quantiques issu de la ou des post-sélections de qbits » et « vecteur d'états quantiques du ou des qbits post-sélectionnés » sont indifféremment employés dans la suite de la description.

L'étape de filtrage de fixation S3 est par exemple effectuée par l'itérateur 7, et notamment par application du filtre F1 illustré sur la figure 1.

L'étape de filtrage de fixation S3 est par exemple située entre l'étape de post-sélection S2 et l'étape de récupération S5, décrite ci-après.

L'étape de filtrage de fixation S3 comprend notamment la fixation de valeurs d'états quantiques du vecteur d'états quantiques issu de la post-sélection.

L'étape de filtrage de fixation permet notamment à l'itérateur 7 de ne pas avoir à parcourir tout le vecteur d'états quantiques issu de la post-sélection de qbits lors de sa récupération sur le terminal applicatif 6.

Plus précisément, si, sur un vecteur d'états quantiques issu de la post-sélection de qbits de n états quantiques, trois états quantiques sont fixés lors de l'étape de filtrage de fixation, un vecteur de taille 2ⁿ⁻³ est récupéré au moyen de l'itérateur 7, et non plus un vecteur quantique de taille 2ⁿ.

L'étape de filtrage de fixation permet donc, en outre, de réduire la taille de l'information à transmettre vers le terminal applicatif.

Une étape de filtrage supplémentaire S4 effectuée.

L'étape de filtrage supplémentaire S4 est mise en œuvre par l'itérateur 7.

Par exemple, l'étape de filtrage supplémentaire S4 peut comprendre un filtrage de seuil et/ou un filtrage de valeur des états quantiques du vecteur d'états quantiques issu de la post-sélection de qbits.

Le filtrage de seuil comprend notamment la définition d'un seuil de probabilité pour lequel les états quantiques associés à une probabilité se situant en-dessous de ce seuil ne sont pas conservés.

Le filtrage de seuil est effectué par application du filtre F2 illustré sur la figure 1.

Le filtrage de valeur comprend notamment la définition d'une valeur d'états quantiques pour laquelle les états quantiques du vecteur d'états quantiques issu de la post-sélection de qbits ayant cette valeur ne sont pas récupérés.

Le filtrage de valeur est effectué par application du filtre F3 illustré sur la figure 1.

Cette étape de filtrage supplémentaire S4 permet, d'une part, de réduire la taille de l'information à échanger vers le terminal applicatif 6 en supprimant certains états quantiques du vecteur d'états quantiques issu de la post-sélection de qbits, et, d'autre part, d'augmenter la complétude de l'analyse en se focalisant seulement sur les états quantiques jugés intéressants.

Les types de filtrage peuvent être combinés et/ou superposés pour plusieurs états quantiques du vecteur d'états quantiques.

Selon un mode de réalisation, les étapes de filtrage de fixation S3 et de filtrage supplémentaire S4 peuvent être suivies par une étape de renormalisation du vecteur d'états quantiques filtré lors de laquelle la probabilité de chaque état quantique conservé dans le vecteur d'états quantiques filtré est modifiée afin que la somme des probabilités de chaque état quantique soit égale à 1.

Puis, une étape de récupération S5, par l'itérateur 7, de tout ou d'une partie des états quantiques du ou des vecteurs d'états quantiques issu(s) de la post-sélection de qbits et filtré(s) est effectuée.

L'étape de récupération S5 peut également comprendre la récupération, par l'itérateur 7, de tout ou d'une partie des états quantiques du ou des vecteurs d'états quantiques issus de la post-sélection de qbits et issus des différents types de filtrage, décrits en référence aux étapes de filtrage de fixation S3 et de filtrage supplémentaire S4.

L'étape de récupération S5 peut en outre comprendre la récupération de chacune des probabilités associées à chaque état quantique du vecteur d'états quantiques récupéré, renormalisé ou non.

Notamment, l'itérateur 7 est apte à identifier un paramètre représentatif de la probabilité de chaque état quantique du vecteur d'états quantiques, entre l'étape de post-sélection et l'étape de récupération, par exemple avant l'étape de filtrage de fixation.

L'itérateur 7 est par exemple apte à lire le vecteur d'états quantiques, et d'associer une probabilité à chaque état quantique. L'itérateur est en outre apte, à partir d'un modèle complexe de type « matrice de stabilisateur » ou « matrice stabilizer » en anglais, de recalculer les éléments de la matrice pour les mettre sous forme d'un vecteur d'états quantiques lisible et d'associer une probabilité à chaque état quantique de ce vecteur d'états quantiques.

L'itérateur 7 est configuré pour itérer sur chacun des états quantiques du vecteur d'états quantiques obtenu après l'étape S4, et éventuellement sur les probabilités qui leur sont associées, afin qu'un analyste puisse y avoir accès depuis le terminal applicatif 6 pour une étape d'analyse S6.

L'étape d'analyse S6 comprend par exemple la comparaison des états quantiques du vecteur d'états quantiques récupérés avec les états quantiques du vecteur d'états quantiques attendu suite aux étapes de post-sélection S2 et de filtrage de fixation S3.

A l'étape de débogage S7, les données issues de l'analyse peuvent être utilisées à des fins de débogage de l'exécution du circuit quantique.

Le procédé est implémenté sur une interface de programmation d'application (ou « API »), apte à accéder au serveur 4.

En variante, le filtrage de seuil comprend la définition d'un seuil de probabilité pour lequel les états quantiques associés à une probabilité se situant au-dessus de ce seuil ne sont pas conservés.

En variante, le filtrage de valeur comprend notamment la définition d'une valeur d'états quantiques pour laquelle uniquement les états quantiques du vecteur d'états quantiques issu de la post-sélection de qbits ayant cette valeur sont récupérés.

### Application industrielle

L'invention peut trouver à s'appliquer notamment dans le domaine de l'informatique quantique et du débogage d'exécution de circuits quantiques.

L'invention ne se limite pas aux exemples décrits ci-avant, seulement à titre d'exemple, mais elle englobe toutes les variantes que pourra envisager l'homme de l'art dans le cadre de la protection recherchée.

### Liste des signes de référence

- 1 : Système
- 2 :simulateur quantique
- 3 : mémoire
- 4 : serveur
- 5 : interface de communication
- 6 : terminal applicatif
- 7 : itérateur
- 8a, 8b : mémoires tampon
- S1 : étape de simulation
- S2 : étape de post-sélection
- S3 : étape de filtrage de fixation
- S4 : étape de filtrage supplémentaire
- S5 : étape de récupération
- S6 : étape d'analyse
- S7 : étape de débogage

## Revendications

1. Procédé d'analyse d'une simulation de l'exécution d'un circuit quantique, comprenant :
- une étape de post-sélection (S2) d'une ou de plusieurs valeurs particulières d'un ou de plusieurs qbits à plusieurs étapes de la simulation, effectuée en sortie de mesure dudit ou desdits qbits suite à une opération par une porte quantique sur ledit ou lesdits qbits, de manière à post-sélectionner une ou plusieurs branches de l'exécution dans l'arbre d'exécution obtenu par ladite simulation, l'arbre d'exécution comprenant des nœuds représentant chaque qbit du vecteur d'états quantiques, deux branches partant de chaque nœud, chaque branche représentant un état quantique du qbit mesuré,
- une étape de filtrage de fixation (S3) fixant la valeur d'un ou de plusieurs états quantiques du ou des vecteurs d'états quantiques issus de la ou des post-sélections de qbits,
- une étape d'analyse (S6) de la partie de ladite simulation correspondant au ou aux post-sélections de qbits et au(x) vecteur(s) d'états quantiques filtré(s),
- entre l'étape de post-sélection (S2) et l'étape d'analyse (S6), une étape de filtrage de valeur (S4), sélectionnant une valeur d'un état quantique pour laquelle les états quantiques correspondants sont conservés dans le vecteur d'états quantiques,
- une étape de communication d'états quantiques d'un ou de plusieurs vecteurs d'états quantiques entre d'une part un simulateur (2) dans lequel ces états quantiques sont stockées et d'autre part un terminal applicatif (6) déporté du simulateur (2) et dans lequel ces états quantiques vont être analysés,
- ces états quantiques étant communiqués en plusieurs fois, entre une mémoire (3) du simulateur (2) et une mémoire tampon (8a) du simulateur (2) dont la taille est strictement inférieure à la taille de la mémoire (3) stockant ces états quantiques dans le simulateur (2), puis entre ladite mémoire tampon (8a) du simulateur (2) et une mémoire tampon (8b) dudit terminal applicatif (6) dont la taille est strictement inférieure à la taille de la mémoire (3).

2. Procédé d'analyse d'une simulation de l'exécution d'un circuit quantique selon la revendication précédente, **caractérisé en ce qu'**il comprend, entre l'étape de post-sélection (S2) et l'étape d'analyse (S6) :
- une étape de récupération (S5), par un itérateur (7), de tout ou partie des états quantiques du ou des vecteurs d'états quantiques issus de la ou des post-sélections de qbits.

3. Procédé d'analyse d'une simulation de l'exécution d'un circuit quantique selon la revendication précédente, **caractérisé en ce qu'**il comprend, entre l'étape de post-sélection (S2) et l'étape d'analyse (S6), et après l'étape de filtrage par fixation (S3):
- l'étape de récupération (S5), par un itérateur quantique, de tout ou partie des états quantiques du ou des vecteurs d'états quantiques issus de la ou des post-sélections de qbits.

4. Procédé d'analyse d'une simulation de l'exécution d'un circuit quantique selon l'une des revendications 2 ou 3, **caractérisé en ce qu'**il comprend :
- une étape d'identification de chaque état quantique dudit ou desdits vecteur(s) d'états quantiques et d'un paramètre représentatif d'une probabilité qui est respectivement associé auxdits chaque état quantique, située entre l'étape de post-sélection (S2) et l'étape de récupération (S5),
- l'étape de récupération (S5) comprenant en outre la récupération de chaque paramètre représentatif de la probabilité respectivement associé à chaque état quantique.

5. Procédé d'analyse d'une simulation de l'exécution d'un circuit quantique selon l'une des revendications précédentes, **caractérisé en ce que** :
- la taille de la mémoire tampon (8a, 8b), au niveau du terminal applicatif (6) et au niveau du simulateur (2), est suffisamment grande pour que le temps de traitement du contenu de cette mémoire tampon (8a, 8b) par le terminal applicatif (6) soit supérieur au temps de transfert des données communiquées entre le simulateur (2) et le terminal applicatif (6).

6. Procédé d'analyse d'une simulation de l'exécution d'un circuit quantique selon l'une des revendications précédentes, **caractérisé en ce que** :
- la taille de la mémoire tampon (8a, 8b) vaut entre 1 Mo et 100Mo, de préférence entre 3Mo et 20Mo.

7. Procédé d'analyse d'une simulation de l'exécution d'un circuit quantique selon l'une quelconque des revendications précédentes, **caractérisé en ce que** :
- l'étape d'analyse (S6) est suivie par une étape de débogage (S7) de l'exécution du circuit quantique.

8. Procédé d'analyse d'une simulation de l'exécution d'un circuit quantique selon l'une quelconque des revendications précédentes, **caractérisé en ce qu'**il comprend, entre l'étape de post-sélection (S2) et l'étape d'analyse(S6) :
- une étape de filtrage de seuil (S4) fixant un seuil de probabilité en dessous duquel les états quantiques correspondants sont supprimés du vecteur d'états quantiques auquel ils appartiennent.

9. Procédé d'analyse d'une simulation de l'exécution d'un circuit quantique selon l'une quelconque des revendications précédentes, **caractérisé en ce qu'**il comprend, suite à l'étape de filtrage de fixation (S3) :
- une étape de renormalisation du vecteur d'états quantiques, de sorte que la somme des probabilités des états quantiques conservés dans ce vecteur d'états quantiques vaille encore 1.

10. Procédé d'analyse d'une simulation de l'exécution d'un circuit quantique selon l'une quelconque des revendications précédentes, **caractérisé en ce qu'**il :
- est intégré dans une interface de programmation d'application (API) apte à accéder à un serveur (4) incluant un simulateur (2) d'exécution du circuit quantique et un module de communication (5) avec un terminal applicatif (6) déporté par rapport au simulateur (2).

11. Procédé d'analyse d'une simulation de l'exécution d'un circuit quantique selon l'une quelconque des revendications précédentes, **caractérisé en ce que** :
- le nombre de qbits du circuit quantique est compris entre 2 et 1000.

## Patentansprüche

1. Verfahren zur Analyse einer Simulation der Ausführung einer Quantenschaltung, umfassend:
- einen Schritt der Nachselektion (S2) eines oder mehrerer besonderer Werte eines oder mehrerer qbits in mehreren Schritten der Simulation, die am Ausgang einer Messung des oder der qbits nach einer Operation durch ein Quantengatter an dem oder den qbits durchgeführt wird, um einen oder mehrere Zweige der Ausführung in dem durch die Simulation erhaltenen Ausführungsbaum nachzuselektieren, wobei der Ausführungsbaum Knoten umfasst, die jedes qbit des Quantenzustandsvektors darstellen, wobei zwei Zweige von jedem Knoten ausgehen, wobei jeder Zweig einen Quantenzustand des gemessenen qbit darstellt,
- einen Fixierungsfilterungsschritt (S3), der den Wert eines oder mehrerer Quantenzustände des Quantenzustandsvektors oder der Quantenzustandsvektoren fixiert, die aus der oder den qbit-Nachselektionen stammen,
- einen Analyseschritt (S6) des Teils der Simulation, der der/den qbit-Nachselektion(en) und dem/den gefilterten Quantenzustandsvektor(en) entspricht,
- zwischen dem Nachselektionsschritt (S2) und dem Analyseschritt (S6) einen Wertfilterungsschritt (S4), der einen Wert eines Quantenzustands auswählt, für den die entsprechenden Quantenzustände in dem Quantenzustandsvektor beibehalten werden,
- einen Schritt der Kommunikation von Quantenzuständen eines oder mehrerer Quantenzustandsvektoren zwischen einerseits einem Simulator (2), in dem diese Quantenzustände gespeichert werden, und andererseits einem Anwendungsterminal (6), das vom Simulator (2) entfernt ist und in dem diese Quantenzustände analysiert werden sollen,
- wobei diese Quantenzustände in mehreren Malen kommuniziert werden, zwischen einem Speicher (3) des Simulators (2) und einem Pufferspeicher (8a) des Simulators (2), dessen Größe strikt kleiner ist als die Größe des Speichers (3), der diese Quantenzustände im Simulator (2) speichert, und dann zwischen dem genannten Pufferspeicher (8a) des Simulators (2) und einem Pufferspeicher (8b) des genannten Anwendungsterminals (6), dessen Größe strikt kleiner ist als die Größe des Speichers (3).

2. Verfahren zur Analyse einer Simulation der Ausführung einer Quantenschaltung nach dem vorhergehenden Anspruch, **dadurch gekennzeichnet, dass** es zwischen dem Nachselektionsschritt (S2) und dem Analyseschritt (S6) umfasst:
- einen Abrufschritt (S5), durch einen Iterator (7), aller oder eines Teils der Quantenzustände des oder der Quantenzustandsvektoren, die aus der oder den qbit-Nachselektionen stammen.

3. Verfahren zur Analyse einer Simulation der Ausführung einer Quantenschaltung nach dem vorhergehenden Anspruch, **dadurch gekennzeichnet, dass** es zwischen dem Nachselektionsschritt (S2) und dem Analyseschritt (S6) und nach dem Fixierungsfilterungsschritt (S3) Folgendes umfasst:
- den Wiederherstellungsschritt (S5), durch einen Quanten-Iterator, aller oder eines Teils der Quantenzustände des Quantenzustandsvektors oder der Quantenzustandsvektoren, die aus der oder den Nachselektionen von qbits stammen.

4. Verfahren zur Analyse einer Simulation der Ausführung einer Quantenschaltung nach einem der Ansprüche 2 oder 3, **dadurch gekennzeichnet, dass** es umfasst:
- einen Schritt zur Identifizierung jedes Quantenzustands des oder der Quantenzustandsvektoren und eines Parameters, der eine Wahrscheinlichkeit darstellt, die jeweils mit den jeweiligen Quantenzuständen verbunden ist, der zwischen dem Nachselektionsschritt (S2) und dem Wiederherstellungsschritt (S5) liegt,
- wobei der Abrufschritt (S5) ferner das Abrufen jedes Parameters umfasst, der repräsentativ für eine Wahrscheinlichkeit ist, die jeweils mit jedem Quantenzustand assoziiert ist.

5. Verfahren zur Analyse einer Simulation der Ausführung einer Quantenschaltung nach einem der vorhergehenden Ansprüche, **dadurch gekennzeichnet, dass**:
- die Größe des Pufferspeichers (8a, 8b) am Anwendungsterminal (6) und am Simulator (2) ausreichend groß ist, so dass die Zeit für die Verarbeitung des Inhalts dieses Pufferspeichers (8a, 8b) durch das Anwendungsterminal (6) größer ist als die Zeit für die Übertragung der zwischen dem Simulator (2) und dem Anwendungsterminal (6) kommunizierten Daten.

6. Verfahren zur Analyse einer Simulation der Ausführung einer Quantenschaltung nach einem der vorhergehenden Ansprüche, **dadurch gekennzeichnet, dass**:
- die Größe des Pufferspeichers (8a, 8b) zwischen 1 Mo und 100 Mo, bevorzugt zwischen 3 Mo und 20 Mo, beträgt.

7. Verfahren zur Analyse einer Simulation der Ausführung einer Quantenschaltung nach einem der vorhergehenden Ansprüche, **dadurch gekennzeichnet, dass**:
- auf den Analyseschritt (S6) ein Debugging-Schritt (S7) der Ausführung der Quantenschaltung folgt.

8. Verfahren zur Analyse einer Simulation der Ausführung einer Quantenschaltung nach einem der vorhergehenden Ansprüche, **dadurch gekennzeichnet, dass** es zwischen dem Nachselektionsschritt (S2) und dem Analyseschritt (S6):
- einen Schwellenwert-Filterschritt (S4), der einen Wahrscheinlichkeitsschwellenwert festlegt, unterhalb dessen die entsprechenden Quantenzustände aus dem Quantenzustandsvektor, zu dem sie gehören, entfernt werden.

9. Verfahren zur Analyse einer Simulation der Ausführung einer Quantenschaltung nach einem der vorhergehenden Ansprüche, **dadurch gekennzeichnet, dass** es im Anschluss an den Fixierungsfilterungsschritt (S3) umfasst:
- einen Schritt der Renormalisierung des Quantenzustandsvektors, so dass die Summe der Wahrscheinlichkeiten der in diesem Quantenzustandsvektor erhaltenen Quantenzustände noch 1 beträgt.

10. Verfahren zur Analyse einer Simulation der Ausführung einer Quantenschaltung nach einem der vorhergehenden Ansprüche, **dadurch gekennzeichnet, dass** es:
- in eine Anwendungsprogrammierschnittstelle (API) integriert ist, die dazu ausgebildet ist, auf einen Server (4) zuzugreifen, der einen Simulator (2) für die Ausführung der Quantenschaltung und ein Kommunikationsmodul (5) mit einem Anwendungsterminal (6) umfasst, das in Bezug auf den Simulator (2) versetzt ist.

11. Verfahren zur Analyse einer Simulation der Ausführung einer Quantenschaltung nach einem der vorhergehenden Ansprüche, **dadurch gekennzeichnet, dass**:
- die Anzahl der qbits der Quantenschaltung zwischen 2 und 1000 liegt.

## Claims

1. . Method for analyzing a simulation of the execution of a quantum circuit, comprising:
- a step of post-selecting (S2) one or more particular values of one or more qubits at one or more steps of the simulation, carried out at the output of the measurement of said qubit(s) after a quantum gate operation on said qubit(s), so as to post-select one or several branches of execution in the execution tree obtained by said simulation, the execution tree comprising nodes representing each qubit of the vector of quantum states, two branches originating from each node, each branch representing a quantum state of the measured qubit,
- a step of setting filtration (S3) that sets the value of one or more quantum states of the quantum state vector(s) derived from the post-selection(s) of qubits,
- a step of analyzing (S6) the part of said simulation that corresponds to the post-selection(s) of qubits and to the quantum state vector(s) filtered,
- between the step of post-selection (S2) and the step of analysis (S6), a step of value filtration (S4), selecting a value of a quantum state for which the corresponding quantum states are kept in the quantum state vector,
- a step of communicating quantum states of one or more quantum state vectors between a simulator (2) in which those quantum states are stored and an application terminal (6) separate from the simulator (2) and in which those quantum states will be analyzed,
- as those quantum states are communicated in multiple installments between a memory (3) of the simulator (2) and a buffer memory (8a) of the simulator (2) the size of which is strictly smaller than the size of the memory (3) storing those quantum states in the simulator (2), then between said buffer memory (8a) of the simulator (2) and a buffer memory (8b) of the application terminal (6) the size of which is strictly smaller than the size of the memory (3).

2. . Method for analyzing a simulation of the execution of a quantum circuit according to the preceding claim, **characterized in that** it comprises, between the step of post-selection (S2) and the step of analysis (S6):
- a step of retrieving (S5), by an iterator (7), all or some of the quantum states of the quantum state vector(s) derived from the post-selection(s) of qubits.

3. . Method for analyzing a simulation of the execution of a quantum circuit according to the preceding claim, **characterized in that** it comprises, between the step of post-selection (S2) and the step of analysis (S6), and after the setting filtration step (S3):
- the step of retrieving (S5), by a quantum iterator, all or some of the quantum states of the quantum state vector(s) derived from the post-selection(s) of qubits,

4. . Method for analyzing a simulation of the execution of a quantum circuit according to any one of claims 2 or 3, **characterized in that** it comprises:
- a step of identifying each quantum state of said quantum state vector(s) and a parameter representative of a probability that is respectively associated with said each quantum state, located between the step of post-selection (S2) and the step of retrieval (S5),
- the step of retrieval (S5) further comprising the retrieval of each parameter representative of the probability respectively associated with each quantum state.

5. . Method for analyzing a simulation of the execution of a quantum circuit according to any one of the preceding claims, **characterized in that** :
- the size of the buffer memory (8a, 8b), in the application terminal (6) and in the simulator (2) is large enough for the time taken to process the contents of that buffer memory (8a, 8b) by the application terminal (6) to be longer than the time taken to transfer the data communicated between the simulator (2) and the application terminal (6).

6. . Method for analyzing a simulation of the execution of a quantum circuit according to any one of the preceding claims, **characterized in that**:
- the size of the buffer memory (8a, 8b) is between 1 MB and 100 MB, and preferably between 3 MB and 20 MB.

7. . Method for analyzing a simulation of the execution of a quantum circuit according to any one of the preceding claims, **characterized in that**:
- the step of analysis (S6) is followed by a step of debugging (S7) the execution of the quantum circuit.

8. . Method for analyzing a simulation of the execution of a quantum circuit according to any one of the preceding claims, **characterized in that** it comprises, between the step of post-selection (S2) and the step of analysis (S6):
- a step of threshold filtration (S4), setting a probability threshold below which the corresponding quantum states are removed from the quantum state vector to which they belong.

9. . Method for analyzing a simulation of the execution of a quantum circuit according to any one of the preceding claims, **characterized in that** it comprises, following the step of setting filtration (S3):
- a step of renormalizing the quantum state vector, so that the sum of the probabilities of the quantum states kept **in that** quantum state vector is still equal to 1.

10. . Method for analyzing a simulation of the execution of a quantum circuit according to any one of the preceding claims, **characterized in that** it:
- is integrated into an application programming interface (API) capable of accessing a server (4) including a quantum circuit execution simulator (2) and a module (5) for communicating with a remote application terminal (6) separate from the simulator (2).

11. . Method for analyzing a simulation of the execution of a quantum circuit according to any one of the preceding claims, **characterized in that**:
- the number of qubits in the quantum circuit is between 2 and 1000.
